# EUROPEAN PATENT APPLICATION

(11) **EP 4 727 270 A2**
(43) Date of publication of application: **15.04.2026**
(21) Application number: 25207640.1
(22) Date of filing: 09.10.2025
(51) Int. Cl.: H05K 1/18, H05K 3/28, H05K 1/183, H05K 1/03, H05K 3/46, H05K 3/00, H05K 3/30, H05K 3/303

(54) **COMPONENT CARRIER AND METHOD OF MANUFACTURING THE SAME**

(30) Priority: 09.10.2024 CN 202411404365
(71) Applicant: AT & S Austria Technologie & Systemtechnik Aktiengesellschaft, 8700 Leoben (AT)
(72) Inventor: Deng, YanChun, Chongqing, 401133 (CN); Jiang, Jeffrey Mingchuan, Chongqing, 401133 (CN)
(74) Representative: Dilg, Haeusler, Schindelmann Patentanwaltsgesellschaft mbH

(57) **Abstract**

A component carrier (100) which comprises a stack (102) comprising at least one electrically conductive layer structure (104) and at least one electrically insulating layer structure (106), wherein the at least one electrically insulating layer structure (106) has a first main surface (108) and an opposing second main surface (110), and at least one cavity (116) formed in the first main surface (108) of the at least one electrically insulating layer structure (106) and being delimited by a bottom wall (112) and a sidewall (114), wherein a surface of said bottom wall (112) and a surface of said sidewall (114) of the at least one cavity (116) have a different roughness Ra than said first main surface (108) and/or than said second main surface (110) of the at least one electrically insulating layer structure (106).

## Description

### Field of the Invention

The invention relates to a component carrier and to a method of manufacturing a component carrier.

### Technological Background

In the context of growing product functionalities of component carriers equipped with one or more components and increasing miniaturization of such components as well as a rising number of components to be connected to the component carriers such as printed circuit boards, increasingly more powerful array-like components or packages having several components are being employed, which have a plurality of contacts or connections, with ever smaller spacing between these contacts. In particular, component carriers shall be mechanically robust and electrically reliable so as to be operable even under harsh conditions.

### Summary of the Invention

There may be a need to form a component carrier with accurately defiance cavity and in a simple way.

According to an exemplary embodiment of the invention, a component carrier is provided which comprises a stack comprising at least one electrically conductive layer structure and at least one electrically insulating layer structure, wherein the at least one electrically insulating layer structure has a first main surface and an opposing second main surface, and at least one cavity formed in the first main surface of the at least one electrically insulating layer structure and being delimited by a bottom wall and a sidewall, wherein a surface of said bottom wall and a surface of said sidewall of the at least one cavity have a different roughness Ra than said first main surface and/or than said second main surface of the at least one electrically insulating layer structure.

According to another exemplary embodiment of the invention, a method of manufacturing a component carrier is provided, wherein the method comprises providing a stack comprising at least one electrically conductive layer structure and at least one electrically insulating layer structure, wherein the at least one electrically insulating layer structure has a first main surface and an opposing second main surface, forming at least one cavity in the first main surface of the at least one electrically insulating layer structure and being delimited by a bottom wall and a sidewall, and forming the at least one cavity so that a surface of said bottom wall and a surface of said sidewall of the at least one cavity have a different roughness Ra than said first main surface and/or than said second main surface of the at least one electrically insulating layer structure.

In the context of the present application, the term "component carrier" may particularly denote any support structure which is capable of accommodating one or more components thereon and/or therein for providing mechanical support and/or electrical connectivity and/or thermal connectivity. In other words, a component carrier may be configured as a mechanical and/or electronic and/or thermal carrier for components. A component carrier may comprise a laminated stack, such as a laminated layer stack. In particular, a component carrier may be one of a printed circuit board, an organic interposer and/or inorganic interposer, and an IC (integrated circuit) substrate. A component carrier may also be a hybrid board combining different ones of the above mentioned types of component carriers.

In the context of the present application, the term "stack" may particularly denote a flat or planar sheet-like body. For instance, the stack may be a layer stack, in particular a laminated layer stack or a laminate. Such a laminate may be formed by connecting a plurality of layer structures by the application of mechanical pressure and/or heat. Preferably, the plurality of layer structures are aligned parallel on top of each other. The stack may comprise at least one electrically conductive structure and at least one electrically insulating structure.

In the context of the present application, the term "layer structure" may particularly denote a continuous layer, a patterned layer or a plurality of nonconsecutive islands within a common plane, and it may perform the function of electrical conductivity and/or electrical insulation.

In the context of the present application, the term "cavity" may particularly denote a blind hole or a through hole (for instance a stepped through hole) in the stack of the component carrier. For example, a cavity may be shaped and dimensioned for accommodating an electronic component (such as a semiconductor chip), a heat dissipation block (for instance a copper block or a ceramic block), or another component carrier entirely or partially therein.

In the context of the present application, the term "roughness" may particularly denote the centerline average height Ra of a surface. Ra is the arithmetic mean value of all distances of the profile from the centerline. For instance, the measurement or determination of roughness Ra, as mentioned in the context of the present application, may be carried out according to DIN EN ISO 4287:2010 (which is an industrial standard). Ra may be the arithmetic average of the absolute values of the deviations of the surface from the average surface profile. The unit of roughness parameter Ra is length and roughness parameter Ra may be measured in micrometers or nanometers. The average surface profile may be screened out from the original surface profile, i.e. the measured surface profile, for example by eliminating waviness components of the surface deviations.

In the context of the present application, the term "main surface of a body" may particularly denote one or more largest substantially planar surface area(s) or outermost opposing surfaces of the body (for instance the stack). Usually, for instance substantially cuboid bodies may have two opposing main surfaces in the form of two horizontal surface areas on top and on bottom of the body. Thus, the main surface may be different from the sidewalls of the body.

According to an exemplary embodiment of the invention, a component carrier (such as a printed circuit board or an integrated circuit substrate) has a (preferably laminated) layer stack including an electrically insulating layer structure (for instance a glass core) with a cavity formed in a main surface thereof. The latter may be delimited by a bottom wall and a sidewall with roughness Ra differing from a roughness Ra of a main surface of said electrically insulating layer structure. Advantageously, this component carrier design and a corresponding manufacturing method may allow to selectively adjust the roughness Ra in a surface delimiting said cavity in a different way than the roughness Ra of the delimiting main surface(s) of the electrically insulating layer structure in which said cavity is formed. For instance, when a component (such as a semiconductor chip) is to be embedded in the cavity, a relatively rough cavity may be desired in order to ensure proper adhesion between cavity walls and component. When however the cavity is used for instance for a high-frequency application (for example for designing a hollow waveguide), a cavity with relatively smooth walls may be desired for suppressing losses. Thus, the selective adjustment of the roughness Ra of the cavity may be of utmost advantage for various component carrier applications. Preferably, cavity formation by a combination of laser processing for locally modifying the material of the electrically insulating layer structure and subsequent etching selectively of the modified material has turned out as a powerful method for local roughness Ra adjustment since the light of the laser can flexibly modify the material by adjusting the depth and/or length the light propagates into the material, wherein the depth of the light entering into the material may impact the roughness of the material.

### Detailed Description of Exemplary Embodiments

In the following, further exemplary embodiments of the component carrier and the method will be explained.

For example, the roughness Ra of the bottom wall and/or the sidewall of the cavity and/or for the main surfaces of the glass core may be in a range from 300 nm to 5000 nm, in particular in a range from 500 nm to 1000 nm.

In an embodiment, the roughness Ra of said bottom wall and/or said sidewall in the at least one cavity is defined by peaks and valleys. Peaks may denote locally protruding structures, whereas valleys may denote locally retracted structures of the respective walls. An alternating sequence of peaks and valleys may lead to a rough or profiled surface structure corresponding to a certain roughness Ra value. Such kind of profile may be generally determined by the material composition of the component carrier considering the material is inorganic material, in particular, the material is glass material, and the depth of the laser light goes into the glass, and compressive stress of the glass.

In the entire bottom wall or side wall, the surface of glass may have a uniform or substantially uniform roughness. Such kind of texture of glass can improve the adhesion with the encapsulated material, and the adhesion may be the same or may be similar in all areas. There may be no void or delamination between the two layers. Additionally, the stress in the modified area may be also the same or similar, which may avoid cracks of the glass. The laser light emitted to the glass surface may also be uniform. The compressive stress at the primary surface of the glass substrate may be balanced by a tensile stress (also referred to as "central tension") within the interior of the glass substrate.

In an embodiment, at least part of the valleys are arranged along straight valley sections in a plan view on the at least one cavity. Straight valley sections may correspond to a surface portion of the respective cavity wall where an elongate valley section between surrounding peaks has a linear or substantially linear appearance. Such a straight valley section may function as an anchoring line for anchoring of an adhesive attaching film and/or (for instance resin-type) encapsulating material between electrically insulating layer structure and embedded component.

In an embodiment, the roughness Ra of said bottom wall in the at least one cavity is defined by peaks and valleys, wherein a majority of the valleys are arranged along straight valley sections extending substantially parallel to each other in a plan view on the at least one cavity. A majority may denote in particular more than 50% of the valleys. However, in other embodiments, around 50% of the valleys have the aforementioned feature. Said valleys may be arranged essentially parallel to each other and may therefore function as adhesion promoting structures which may enhance mechanical anchoring between an embedded component, cavity walls and connecting material in between. Such valleys arranged at said bottom may all have a uniform or substantially uniform depth or size due to the accurate modification by the laser beam, the material composition and the balanced distribution of comprehensive stress to the material to finally modify the property of material in a uniform manner.

In an embodiment, the majority of the valleys extend along an inclined direction, for instance along a diagonal direction, with respect to said sidewalls. Thus, the above-mentioned anchoring effect may be achieved along spatial contributions concerning both of two mutually perpendicular sidewalls. The valleys may extend along an inclined direction with respect to said sidewalls in a uniform manner. That means that the adhesion between the edge area and encapsulation material may be good. Additionally, the comprehensive stress at the edge can be also balanced and a crack of the component carrier can be avoided.

In an embodiment, the roughness Ra of said bottom wall and/or said sidewall in the at least one cavity is defined by peaks and valleys, wherein a thickness extension of at least a plurality of the peaks creates undercuts along a thickness direction of the stack. Such undercuts may allow excellent anchoring of connecting material (such as an attaching film and/or encapsulating resin) in the cavity between an embedded component and the electrically insulating layer structure.

In the context, the attaching film can be an adhesive material with the adhesive property to connect the component with the cavity bottom wall or can be a non-adhesive material being a filling material to fill in the opening of the cavity bottom wall or recess which may be from roughness formation at the cavity bottom wall to be an intermedium layer between the cavity bottom wall and component as a bonding interface.

In an embodiment, the roughness Ra of said bottom wall and/or said sidewall in the at least one cavity is defined by peaks and valleys, wherein a thickness extension of at least a plurality of the peaks on the bottom wall follows a different direction with respect to a thickness extension of at least a plurality of the peaks on the sidewall. For instance, the valleys may extend in a direction or thickness extension substantially vertically into the bottom wall, whereas the valleys may extend in a direction or thickness extension substantially horizontally into the sidewalls. The depth or size of valleys arranged at the sidewall and the depth or size of valleys arranged at the bottom wall may be different, and/or the height or size of peaks arranged at the sidewall may be different from the height or size of peaks arranged at the bottom wall. This kind of structure may provide different level of adhesion based on the actual requirement for an application of the component carrier. This may be due to the fact that, in certain applications, a component placed in the cavity may need stronger adhesion with said bottom wall to prevent delamination between the component and the component carrier due to the CTE (coefficient of thermal expansion) mismatch between materials of the component and the component carrier.

In an embodiment, the roughness Ra of said bottom wall and/or said sidewall in the at least one cavity is defined by peaks and valleys, wherein undercuts are provided in the at least one cavity along a thickness direction of the stack by different extensions of the peaks. In particular, the peaks may have vertical sections and horizontal sections which may together form said undercuts. The latter may significantly improve the adhesion promoting effect of the cavity walls as the undercuts may provide an anchoring point for the edge of the cavity to improve the adhesion at the bonding interface between the said bottom wall and/or sidewall and the encapsulation material.

In an embodiment, the roughness Ra of said bottom wall and/or said sidewall in the at least one cavity is defined by peaks and valleys, wherein said valleys divide said peaks into islands (preferably adjacent islands) each comprising at least one of said peaks, for example a plurality of said peaks. Each island may be surrounded by valleys so as to form a rock-like profile. This may function as an efficient adhesion promoter. Additionally such kind of profile may be already structured at a distance or accuracy that the material can be modified and later on be removed without crack or damage of the component carrier.

In an embodiment, at least part of said islands has, in a plan view of the at least one cavity, a length in a range from 0.2 µm to 15 µm, for example in a range from 0.5 µm to 5 µm, in at least one horizontal direction. Islands of such a shape may function in an excellent way as anchoring structures.

In an embodiment, the peaks at the said bottom wall or said sidewall have the same height or size, and the valleys at said bottom wall or said sidewall have the same depth or size. That means that the profile at the entire bottom wall or side walls may be arranged in a uniform manner. Therefore, a good encapsulation may be guaranteed in the cavity. Furthermore, bubbles or voids may be avoided in the encapsulation material. Beyond this, this may also lead to a flat surface on the dielectric layer surface of the build-up. Meanwhile the distribution of the center strength from the component carrier during the laser treatment and after the laser treatment can be distributed evenly, thus a risk of crack or damage can be avoided, in particular at the glass component carrier.

In one embodiment, the peaks at said bottom wall and at said sidewall may have the same height or size, and the valleys at said bottom wall and said sidewall may have the same depth or size. This may lead to the same roughness on the bottom wall and the side walls of said cavity, which may result from the laser modification to materials at the same level and may result in an even distribution of the inner stress or comprehensive stress in the whole cavity. Finally the crack and damage for the inorganic layer structure or even warpage for the whole component carrier can be controlled.

In another embodiment, the peaks at said bottom wall and said sidewall have different height or size, and the valleys at said bottom wall and said sidewall have different depth or size. This may lead to different roughness on the bottom wall and the side walls of the said cavity, which may result from the laser modification to materials at the different level. As long as the roughness on the cavity surface is controlled within the tolerance, the whole component carrier will not get damaged and such kind of different texture of surface can be used in different applications. This structure and method may provide the flexibility in manufacturing for the component carrier and final application.

In an embodiment, at least one of said valleys is configured as a corridor adjacent to a plurality of said islands. Also such corridor-type structures delimiting different islands of peaks may contribute to a pronounced surface profile and thus an efficient increase of roughness. Such kind of corridor-type structures may be due to the accurate control from the laser modification (change of property) to materials, in particular to a glass, so as to form the cavity.

In an embodiment, said bottom wall and said sidewall are connected to each other by a transitional wall, for example a rounded wall. For example, the bottom wall may be substantially horizontal, whereas an exterior portion of the sidewall may be substantially vertical or slanted. In between these substantially straight sections, a rounded interface may be provided. The round interface at the transitional wall may get less laser treatment during the laser modification to materials, therefore the degree of cracks may be much less. The round interface may provide a buffer for the centre stress spreading from center to a circumference. Moreover, the round interface may reduce the risk of cracks of the whole component carrier, in particular for the glass component carrier.

In an embodiment, the transitional wall (which may be a rounded wall) has a different roughness from the bottom wall and the sidewall, in particular a smaller roughness. The round characteristic in this area may constitute a buffer area for the stress spread to the edge from the bottom and the sidewall. Therefore, cracks at the corner of the cavity, which may cause damage or crack of the whole component carrier, may be reliably avoided.

In an embodiment, the roughness Ra of said bottom wall and/or said sidewall and/or said transitional wall in the at least one cavity is defined by peaks and valleys, wherein a thickness extension of the peaks on the transitional wall is different from a thickness extension of the peaks on the bottom wall and/or the sidewall. Hence, the transitional wall may provide a continuous transition between the thickness extensions of the peaks in the respective wall portions on both sides thereof. In another embodiment, the thickness extension in bottom wall and sidewall as well as in the transitional wall may also be the same.

In an embodiment, the thickness extension of the peaks on the transitional wall varies, for example gradually varies, from the thickness extension of the peaks on the bottom wall to the thickness extension of the peaks on the sidewall. Thus, the transitional wall may provide a smooth transition between bottom wall and sidewall, which may improve the mechanical integrity of the component carrier as a whole.

In an embodiment, the sidewall of the at least one cavity is substantially perpendicular to said first main surface and/or said second main surface, for example within a deviation of ±10°, for example ±5°. Highly advantageously, the combination of a spatially-resolved glass material modification by a controlled laser beam and a subsequent selective removal of the modified glass material only by wet etching may lead to almost vertical sidewalls. A deviation of ±10° may be significantly less than a deviation obtained with conventional approaches of forming a cavity in an electrically insulating layer structure. The steeply slanted or even almost vertical sidewalls obtained by exemplary embodiments may bring the advantage that an electronic component with rectangular cross-section can be embedded in a controlled and space-saving way in the cavity. With such accuracy for said deviation, the capability to form the substantially straight cavity sidewall can make the cavity size match with the component size in different applications. What's more, the accuracy can avoid the occupation of area for the surface of the component carrier, so that the surface area can be used for the cavity in a minimum manner and more routing or wiring structure can be arranged on the surface. Therefore, this may be advantageous for a high density and fine line structuring component carrier, for instance applied for high performance computing.

In an embodiment, said first main surface and/or said second main surface is or are planar. In particular, the electrically insulating layer structure in which the at least one cavity is formed may be plate-shaped. Preferably, the electrically insulating layer structure may be an inorganic plate such as a glass plate, a ceramic plate or a semiconductor plate.

In an embodiment, said surface of said bottom wall has another roughness Ra than said surface of said sidewall. However, bottom wall and sidewall can also have the same roughness. The different roughness or the same roughness can be controlled by the laser modification to material accurately. With such an embodiment, the roughness can be adjusted flexibly based on a final product requirement and/or a manufacturing process requirement.

In an embodiment, said surface of said bottom wall has a higher roughness Ra than said surface of said sidewall. This may lead to an excellent connection between the particularly rough bottom wall and an adhesive attaching film which may be formed on a bottom main surface of a component to be embedded in the cavity. Since gaps between sidewalls of cavity and component may be filled by flowable resin or the like, lateral adhesion may be less problematic than adhesion of the component on its bottom side.

In an embodiment, said roughness Ra of said surface of said bottom wall and/or of said surface of said sidewall provide an anchoring boundary region for anchoring an attaching film and/or an encapsulating material at said bottom wall and/or said sidewall of the at least one cavity. Consequently, exemplary embodiments may allow for a highly reliable and precise embedding of a component in the cavity.

In an embodiment, a plurality of cavities are formed in the first main surface of the at least one electrically insulating layer structure, each of said cavities being delimited by a respective bottom wall and a respective sidewall. Different cavities may be arranged side-by-side, for instance at the same vertical level. It may also be possible to form different cavities at different vertical levels, for instance at least one cavity in the first main surface and at least one cavity in the second main surface of the electrically insulating layer structure. Different cavities may have the same or different shapes and/or dimensions.

In an embodiment, different ones of said cavities have different sizes, in particular in a horizontal plane and/or in a vertical direction. Such an embodiment of the invention can accurately allow to achieve different size and may allow to modify different levels of material. Hence, it may be possible to form cavities of different horizontal area and/or different depths in the same electrically insulating layer structure. For instance, different lateral extensions of different cavities may be defined by laser scanning areas of different size on the respective main surface of the electrically insulating layer structure. Different depths of different cavities may be defined by adjusting different focusing depths of the laser beam impacting the electrically insulating layer structure. This may define a depth up to which glass material is modified by the laser impact, so that the respective modified glass material up to said depth may be subsequently removed by wet etching.

In an embodiment, the component carrier comprises at least one component embedded in the at least one cavity. In the context of the present application, the term "component embedded in the at least one cavity" may particularly denote a component being fully accommodated or only partially accommodated in the cavity. In a fully accommodated embodiment, the entire vertical spatial range between upper end and lower end of the component is located inside of the cavity. In a partially accommodated embodiment, only part of a vertical spatial range between upper end and lower end of the component is located inside of the cavity, for instance the component may protrude upwardly and/or downwardly beyond the cavity. In one embodiment, the upper end of the at least partially accommodated component may be in alignment with an upper main surface of the electrically insulating layer structure and/or the lower end of the component may be in alignment with a lower main surface of the electrically insulating layer structure. For instance, the component may be an electrical component for providing an electrical function (such as a semiconductor chip), a thermal component for providing a cooling function (such as a copper or ceramic block) and/or an optical component providing an optical function. For example, the cavity may be shaped and dimensioned for accommodating an electronic component (such as a semiconductor chip), a heat dissipation block (for instance a copper block or a ceramic block), or another component carrier entirely or partially therein.

Preferably, filling the gaps between component and cavity walls with encapsulant material and laminating a further (preferably organic) electrically insulating layer structure (for instance a sheet comprising curable resin) on the cavity-containing (preferably inorganic) electrically insulating layer structure may be carried out by a single common lamination process using the same lamination material which flows partially inside the gaps and which remains partially on the top main surface of the cavity-containing electrically insulating layer structure.

In an embodiment, the component carrier comprises an attaching film in said at least one cavity, wherein the at least one component is attached by the attaching film. In one embodiment, the attaching film is already pre-attached to the bottom side of the component, so that only one body needs to be inserted into the cavity. Thus, the component can be bonded with the bottom wall firmly after the curing process. In another embodiment, the attaching film may be formed at the bottom wall of the cavity (for instance by inserting a solid adhesive tape in the cavity or by dispensing glue into the bottom of the cavity) prior to inserting the component on said attaching film.

In an embodiment, the electrically insulating layer structure comprises or consists of glass. Generally, the electrically insulating layer structure may comprise or consist of glass, a ceramic, a semiconductor, a quartz or a metal. Thus, appropriate materials for the electrically insulating layer structure are glass (in particular silicon-based glass), a ceramic (such as aluminum nitride and/or aluminum oxide), and a material comprising a semiconductor (such as silicon oxide, silicon, silicon carbide, gallium nitride, etc.). It is also possible to make the inorganic layer structure of a metallic material, such as copper.

In an embodiment, the electrically insulating layer structure comprises or consists of glass. In particular, the electrically insulating layer structure may be a glass core or glass plate. Most preferred is an electrically insulating layer structure which comprises glass or consists of glass. Such an electrically insulating layer structure may comprise or consist of silicon dioxide. In particular, the electrically insulating layer structure may have glass as main constituent. For example, the electrically insulating layer structure may be block-, strip- or plate-shaped. The major material component (in particular the material component of the electrically insulating layer structure providing the highest weight percentage) of the electrically insulating layer structure is glass, in particular silicon-based glass. For instance, at least 90 weight percent of the electrically insulating layer structure may be glass. For example, the electrically insulating layer structure may consist only of glass. It is however also possible that the electrically insulating layer structure comprises one or more additional other materials. Advantageously, the electrically insulating layer structure may have very flat surfaces so that a planarization stage during processing may be dispensable and fine line processing thereon or above it may be fully supported. Furthermore, the electrically insulating layer structure may have a high degree of thermal stability so that thermally-caused undesired phenomena such as thermal stress, shrinkage, warpage and delamination will not impact the component carrier significantly. This can make the whole component carrier stable with controllable change of the dimension of the component carrier (such as shrinkage would be less), so the alignment of all elements related to the component carrier may be improved (such as layer to layer alignment, via to pad alignment, pad to via alignment, bump to opening alignment, etc.). Besides that, the coplanarity of components assembled on the component carrier may be improved (such as bumps, capacitors, etc.). Furthermore, glass material may show a low Dk and low Df behavior with good dielectric property and may therefore support low loss, high-frequency (in particular improving radio frequency, RF) and high-speed applications as well as high performance computing application with good signal integrity and low loss.

In an embodiment, the surface of said bottom wall and the surface of said sidewall have a higher roughness Ra than said first main surface and/or than said second main surface. This may be advantageous for applications in which a component is to be assembled and connected in the cavity, since the locally increased roughness Ra may promote adhesion of such a component in the cavity and may therefore improve accuracy and reliability of the embedding process.

In an embodiment, a minimum horizontal distance between the first main surface and the bottom wall is not more than 50 µm, for example not more than 15 µm and preferably not more than 10 µm. Thus, the sidewalls of the cavity may be very steep so that an almost rectangular cross-section of the cavity may be obtained. This may allow to assemble a component in the cavity with low space consumption and high spatial precision. Due to the combination of laser modification of glass materials and subsequent wet etching, significantly steeper sidewalls may be achieved as compared with conventional approaches. With such kind of structure, the alignment between the component and the component carrier, as well as the layer to layer alignment may be improved. Additionally, the encapsulation of the cavity may be also good without void.

In an embodiment, a depth of the at least one cavity is in a range from 10 µm to 200 µm, for example from 30 µm to 100 µm, preferably from 40 µm to 80 µm. For example, a depth of the cavity may be about 60 µm. Such cavity dimensions are compatible with modern semiconductor chip dimensions.

In another embodiment, the cavity has a depth of at least 500 µm, in particular of at least 700 µm. Advantageously, such a large cavity depth may be capable of supporting a number of high-tech applications, for instance an optical package comprising at least one optical component embedded in the cavity.

In an embodiment, the method comprises forming the at least one cavity using a laser treatment. In particular, the method comprises forming the cavity by processing the stack with a laser beam, in particular a Bessel beam. Single laser beam-processing or multiple laser beam-processing are possible. Said laser beam may be specifically configured for attacking bonds of the material of the electrically insulating layer structure. For instance, when the electrically insulating layer structure comprises glass, the laser beam may be specifically adapted for attacking Si-O bonds. This may be done by adjusting laser wavelength, laser pulse length and/or laser energy. Preferred may be a green picosecond laser, in particular with Bessel beam, wherein the Bessel beam may be a non-diffraction beam. Therefore, the beam distribution may be unchanged at the horizontal direction during transmission to the subject. Meanwhile the main diameter of the beam minimum can be a few micrometers, but the depth of focus can reach to a few millimetres. With such an advantageous Bessel beam shot by a picosecond laser, the glass can be modified or cut with accuracy without cracking, and surface roughness control can be achieved by an accurately controlled transmission distance of the beam with efficiency.

In an embodiment, the method comprises forming the at least one cavity using etching, for example wet etching, after said laser treatment. The wet etchant may be specifically adapted for dissolving material of the electrically insulating layer structure which has been selectively modified by a prior laser treatment. For removing modified glass material with pre-attacked Si-O bonds, HF as wet etchant has turned out as highly appropriate. In other embodiments, other etching processes than wet etching may be possible as well. With the etching method, the modified material at the cavity area can be easily removed and no crack or damage may occur on the glass. Since the laser does not remove the material and the etching removes the material, there may be no foreign material generated from cutting. This is a big advantage (what concerns high yield, good reliability) for the manufacture of component carriers, in particular for high density and fine line structuring component carriers used for instance in the high performance computing field.

In an embodiment, the method comprises using a laser beam having a wavelength in a range from 520 nm to 580 nm, in particular a green laser, for said laser treatment. For instance, the method comprises forming the cavity by processing with a laser beam having a wavelength below 600 nm, for example in a range from 520 nm to 580 nm, such as 550 nm. A laser beam with the described properties may allow to form the cavity with locally roughened cavity surface.

In an embodiment, the cavity can be formed by a CO₂ laser. The laser beam may promote a complete separation around a perforation line. Then the following laser method may produce through-body incisions of various glasses in a single pass with low subsurface damage.

In an embodiment, it may be possible that a high pressure auxiliary gas is mixed with CO₂.The beams are forced out collinearly through a nozzle to provide additional force to drive the glass material out of the larger glass piece.

In an embodiment, the method comprises using a pulsed laser, for example a picosecond-pulsed laser, for said laser treatment. Preferably, the method comprises forming the pulsed laser beam with laser light pulses having a temporal length and/or a temporal distance of not more than 1 ps. For example, a picosecond laser or femtosecond laser may be used for forming the cavity. In another embodiment, it may also be possible to use a nanosecond laser.

In an embodiment, the method comprises, for said laser treatment, scanning with a laser beam over a surface region of the at least one electrically insulating layer structure in which the at least one cavity is to be formed. In one embodiment, the electrically insulating layer structure or panel may remain spatially fixed while the laser source scans over its surface. In another embodiment, the electrically insulating layer structure or panel may move for scanning while the laser source remains spatially fixed.

In an embodiment, the method comprises focusing, for said laser treatment, laser light to an intended depth of the at least one cavity to be formed in the at least one electrically insulating layer structure. Highly advantageously, the laser beam may be focused to a depth beneath the first main surface of the electrically insulating layer structure. For instance, the laser beam may be focused to a depth in a range from 30 µm to 100 µm, preferably from 40 µm to 80 µm, beneath said main surface. This may allow to precisely define the cavity depth. In another embodiment, the laser beam may be changed with its centre main lobe diameter and transmission distance of non-diffraction. For instance, by reducing the centre main lobe diameter and shortening the transmission distance of non-diffraction, the taper of the laser beam may be enlarged, this can improve the results.

In an embodiment, the method comprises configuring laser light, for said laser treatment, for modifying a glass property of the at least one electrically insulating layer structure in which the at least one cavity is to be formed. The laser light for the depth control may be generated with a laser by using one or more lenses which can have a long light and small focal characteristics, so that the laser light can change the property of glass for a chemical to remove the modified glass. There may be an overlapping focus.

However, other exemplary embodiments may use another etching method than wet etching. Furthermore, other exemplary embodiments may use continuous (rather than pulsed) laser beams and/or laser light in different wavelength ranges than the green laser mentioned above.

In an embodiment, the cavity extends vertically only over a single layer structure. However, in another embodiment, the cavity extends vertically over a plurality of layer structures of the stack. For instance, said plurality of layer structures over which the cavity extends vertically may be at least two, in particular at least three, preferably at least four, or even more than four, for instance at least ten. A corresponding deep cavity without structural artefacts may be formed in particular by using a pulsed laser source, for instance having a pulse length of not more than picoseconds, in particular not more than femtoseconds.

In an embodiment, multiple cavities can be formed in a single layer (such as a core) from the second main surface and first main surface. Furthermore, the component can be embedded in the cavities on two (or more) sides. Advantageously, a density can be improved and a heterogenous package can be realized as well.

In an embodiment, the cavity may be formed in a central portion of the electrically insulating layer structure or the stack. Alternatively, the cavity may be cut at the edge of the electrically insulating layer structure or the stack. Consequently, there may be only three sidewalls, and there may be a side with a lateral opening. With such kind of structure, an external connection element may be easily inserted, connected and/or disconnected with the component carrier (such as an optical plug and/or an unplug element).

In an embodiment, the component carrier comprises an electronic component mounted on or above the electrically insulating layer structure. One or more electronic components may be surface mounted. In the context of the present application, the term "electronic component" may particularly denote a member fulfilling an electronic task. Such an electronic component may be an active component such as a semiconductor chip comprising a semiconductor material, in particular as a primary or basic material. The electronic component may also be a passive component, for instance a capacitor or an inductor. Preferably, the electronic component comprises a semiconductor chip. The semiconductor chip may be made for instance based on a type IV semiconductor such as silicon or germanium, or may be a type III-V semiconductor material such as gallium arsenide. In particular, the semiconductor component may be a semiconductor chip such as a bare die or a molded die. A bare die may be a non-encapsulated (in particular non-molded) piece of semiconductor material (such as silicon) having at least one monolithically integrated circuit element (such as a diode or a transistor). Moreover, semiconductor materials suitable for photonic packages are also possible. For example, an electronic component to be surface mounted on the package may be an HBM (high-bandwidth memory) or a silicon interposer.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. In particular a naked die as example for an electronic component can be surface mounted on a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). A printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board. A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, Melamine derivates, Polybenzoxabenzole (PBO), bismaleimide-triazine resin, polyphenylene derivate (e.g. based on polyphenylenether, PPE), polyimide (PI), polyamide (PA), liquid crystal polymer (LCP), polytetrafluoroethylene (PTFE), Bisbenzocyclobutene (BCB) and/or a combination thereof. Reinforcing structures such as webs, fibers, spheres or other kinds of filler particles, for example made of glass (multilayer glass) in order to form a composite, could be used as well. A semicured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, titanium and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be surface mounted on the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.
Figure 1 and Figure 2 show cross-sectional views of structures obtained during carrying out a method of manufacturing a component carrier according to an exemplary embodiment of the invention.
Figure 3 illustrates a cross-sectional view of a component carrier according to an exemplary embodiment of the invention.
Figure 4 illustrates a three-dimensional image of a component carrier manufactured according to an exemplary embodiment of the invention.
Figure 5 illustrates different cross-sectional views of various portions of a component carrier manufactured according to an exemplary embodiment of the invention.
Figure 6 to Figure 9 show plan views of portions of a component carrier manufactured according to an exemplary embodiment of the invention with difference zooms.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

To meet advanced packaging interconnect scaling trends, glass core substrates may excel organic core substrates in finer pitch or features formation and has good material properties.

To achieve high density advanced packaging of multiple dies, embedding some dies into a glass core panel may be desired. As de-taping from a glass panel may be difficult, a blind hole-type cavity may be a good choice for a glass core.

Current glass cavity formation is done by etching after an ink printing process. However, this method may be insufficient to obtain an accurately designed cavity due to printing ink thickness and alignment and chemical isotropic etching challenges. Therefore, an improved method of glass cavity formation may be desired to solve current glass core fabrication issues.

According to an exemplary embodiment of the invention, a component carrier (for example a PCB or an IC substrate) may be provided with a stack of preferably laminated layers having one or more (preferably blind hole-type) cavities therein. Beneficially, a bottom wall and a sidewall of the cavity may be created with a value of the roughness Ra being different from the roughness of a main surface of said electrically insulating layer structure (for instance an inorganic carrier such as a glass carrier). This brings the advantage that the component carrier design may be adjusted in particular by an appropriate manufacturing method in combination with an appropriate material selection of the electrically insulating layer structure for setting the roughness Ra of a cavity delimiting surface differently from the roughness Ra of at least one of the main surfaces of the corresponding electrically insulating layer structure. By taking this measure, the cavity's roughness may be locally adjusted in accordance with a desired application. Just as an example, such an application may be component embedding in the cavity which may be promoted by a relatively rough cavity thanks to a resulting good adhesion of the component in the cavity. In another example, if the cavity forms part of a high-frequency member such as a waveguide for guiding high-frequency waves in an efficient way, a low roughness Ra of cavity walls may be desired. Advantageously, the cavity may be formed by laser processing for selectively weakening a defined portion of the electrically insulating layer structure material followed by an etching process for finally forming said cavity. By properly defining the parameters and characteristics of such a manufacturing method, roughness Ra of the cavity may be designed in a desired fashion.

According to an exemplary embodiment, a blind cavity formation method in an electrically insulating layer structure of a layer stack, in particular on a glass core panel, is provided. In particular, a bessel beam laser application may be provided to ensure to achieve an accurate depth of a glass property modification for precisely adjusting the cavity depth. Thus, it may be possible to embed components, preferably electronic components such as semiconductor dies, into an electrically insulating layer structure which may be embodied preferably as a glass core.

Exemplary applications of exemplary embodiments of the invention are a glass interposer or substrate, a high performance computing (HPC) device, and an elevated fan-out bridge (EFB) glass interposer product, etc.

In a preferred embodiment, the cavity with property definable roughness Ra in an electrically insulating layer structure of a component carrier may be formed by laser irradiation followed by wet etching. The laser type (in particular its wavelength, a pulse length, etc.) as well as the laser processing parameters may be used for fine-tuning the cavity surface properties, for instance may be used for large sized cavity creation.

According to an exemplary embodiment, a component carrier is provided which comprises a stack comprising at least one electrically conductive layer structure and at least one electrically insulating layer structure, wherein the at least one electrically insulating layer structure has a first main surface and an opposing second main surface, and at least one cavity (such as an opening or a recess) formed at the first main surface of the at least one electrically insulating layer structure and being delimited by a bottom wall and a sidewall, wherein the surface of said bottom wall and sidewall in the cavity has different roughness from said main surface of the at least one electrically insulating layer structure.

Advantageously, the roughness of said bottom wall and/or sidewall in the cavity is defined by peaks and valleys, the valleys being planarly linearly distributed along partially straight directions (in particular another part may be non-straight). In an embodiment, the thickness extension of (in particular at least a plurality of) the peaks follows a direction creating undercuts along the stack thickness direction. For instance, the thickness extension of the peaks on the bottom wall follows a different direction with respect to the thickness extension of the peaks on the sidewall. For example, undercuts are provided in the cavity along the stack thickness direction by the different extensions of the peaks. According to an embodiment, the overall planar linear distribution of a plurality of valleys follows the same planar directions (in particular more than 50% of the valleys planarly follow the same direction). For instance, said planar direction may be a diagonal direction. In an embodiment, the valley distribution divides the surface in adjacent islands, in particular each or the majority of said islands comprising at least one peak in particular a plurality of peaks. For example, the islands may each have a planar extension (along the xy-directions or in the xy-plane) from 0.2 µm to 15 µm. Advantageously, at least one valley may be configured as a corridor adjacent to a plurality of islands. For example, the bottom wall and the side wall are connected one to each other by a transitional wall, preferably a rounded wall (or having a different shape and/or inclination). In an embodiment, the thickness extension of the peaks on the transitional wall is different from the thickness direction of the peaks on the bottom wall and/or the lateral wall. For instance, the thickness extension of the peaks on the transitional wall is variable, in particular it is gradually variable from the thickness direction of the peaks on the bottom wall to the thickness direction of the peaks on the sidewall. With such kind of structure, in the entire bottom wall or side wall, the surface of glass may have a uniform or substantially uniform roughness. Such kind of texture of glass can improve the adhesion with the encapsulated material. In particular, the adhesion may be the same or may be similar in the entire area, thus there may be no void or delamination between the two layers. Additionally, the stress in the modified area may be also the same or similar, which may avoid cracking of the glass. The laser light to the glass surface may be also uniform. This compressive stress at the primary surface of the glass substrate may be balanced by a tensile stress (which may also be referred to as "central tension") within the interior of the glass substrate. Due to advantages provided by embodiments of the invention, the cavity can be formed with a substantially straight angle. For example, the sidewall of the cavity may be perpendicular with respect to the main surfaces of the stack, in particular within a deviation of ±10°. In an embodiment, said first and second main surfaces are planar. In particular, the surface of said bottom wall and said side wall in the cavity may have different roughness. For example, the roughness of said bottom wall is greater than the roughness of said sidewall. For instance, the roughness of the surface of said bottom wall and said sidewall provides an anchoring boundary region with said attaching film or an encapsulating material with the bottom and/or sidewalls of the cavity. In an embodiment, a plurality of cavities is provided, wherein at least two cavities may have different sizes. Advantageously, at least one component may be embedded in the cavity. For example, said component may comprise an attaching film. In an embodiment, the inorganic layer structure consists of glass.

Concerning a method of manufacturing a component carrier, a combination of laser processing and etching may be advantageous. Preferably, the cavity is formed by laser modifying the glass property and subsequently etching by a chemical. Concerning the type of laser source used, a laser source emitting green light may be preferred. According to an exemplary embodiment, a method of forming a blind cavity in an electrically insulating layer structure, preferably in a glass core, may be provided. A component, preferably an electronic component, for example an active and/or a passive semiconductor die, can be embedded in such a (preferably glass) cavity for forming a package-type component carrier. Advantageously, the cavity may be formed by greenlight laser processing followed by wet chemical etching. This may allow to manufacture a cavity with precisely definable roughness which can be different from, preferably larger than, a roughness of main surfaces of the electrically insulating layer structure (preferably a glass core) in which the cavity is formed.

Exemplary embodiments may allow to manufacture a highly accurate cavity in a glass panel. A spatial laser irradiation range or location may be precisely controlled by a laser machine. The depth of the cavity can also be accurately controlled by laser processing and/or by subsequent wet etching parameters. Descriptively speaking, a surface volume in the electrically insulating layer structure in which the cavity is later formed may be defined by correspondingly defined laser processing. This may include a definition of a surface area and a depth in which the cavity will be formed. Only this volume will be selectively modified (in particular mechanically and/or chemically weakened) by the laser processing. A subsequent etching process, preferably a wet etching process, may then selectively remove only the modified region of the electrically insulating layer structure for creating a precisely defined cavity. By adjusting the laser processing properties and/or wet etching properties, in particular the roughness Ra of at least a part of the walls delimiting the cavity may be precisely defined and may be defined in particular differently from (preferably larger than) a roughness Ra of the exterior main surfaces of the electrically insulating layer structure. This may allow to fine-tune the properties of the cavity for a desired application, in particular for embedding of a component with proper adhesion.

More specifically, greenlight laser processing may be followed by a wet chemical anisotropic etching process being selective with respect to laser-modified glass material of the electrically insulating layer structure to form one or more cavities in the electrically insulating layer structure. This may allow to define the positions and the dimensions of blind glass cavities to be accurately formed in a glass panel.

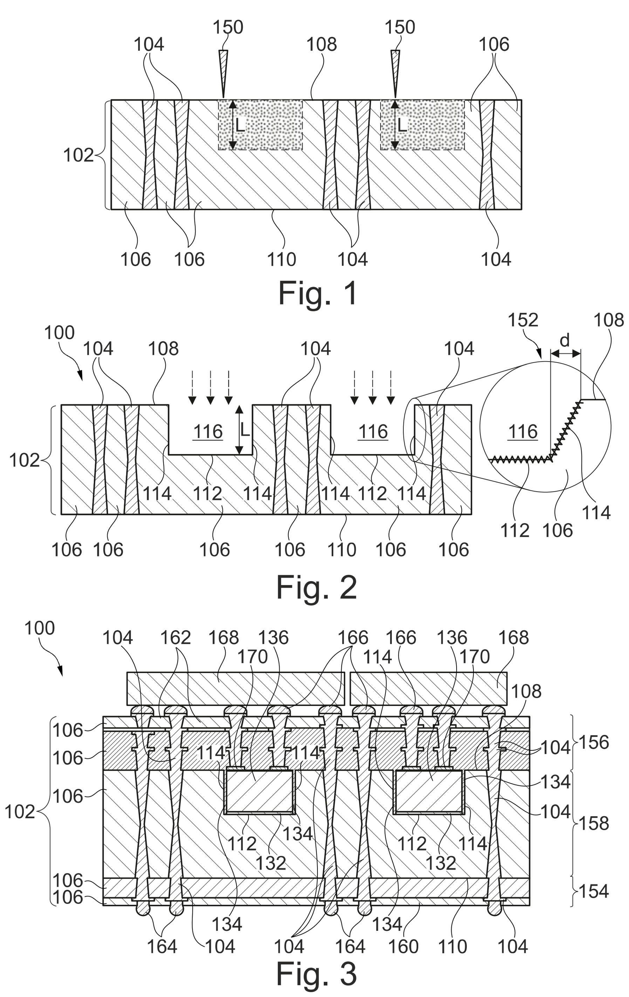

Figure 1 and Figure 2 show cross-sectional views of structures obtained during carrying out a method of manufacturing a component carrier 100 according to an exemplary embodiment of the invention.

Referring to **Figure 1****,** a stack 102 is shown which comprises an electrically insulating layer structure 106 and electrically conductive layer structures 104 therein. The electrically insulating layer structure 106 may be embodied as a glass plate or a glass core. The electrically conductive layer structures 104 are configured as copper filled laser vias extending vertically between a first main surface 108 and an opposing second main surface 110 of the electrically insulating layer structure 106. Thus, a plurality of oblong through holes may be formed in the electrically insulating layer structure 106. The through holes may then be filled with an electrically conductive material such as titanium and copper or copper, for instance by plating or sputtering (for example electroless plating followed by electroplating). In Figure 1, the copper filled laser vias have an hourglass shape (or alternatively a tapering shape or straight shape, depending on a used laser processing method). This means that the laser vias have been formed by laser drilling from one main surface 108, 110 followed by laser drilling from the opposing other main surface 110, 108. Each laser drilling process may create a blind hole in the electrically insulating layer structure 106, wherein both blind holes may connect to form together the hourglass shaped through hole.

Furthermore, blind hole-type cavities 116 are formed in the first main surface 108 of the glass material of the electrically insulating layer structure 106. As shown in Figure 2, each cavity 116 is delimited by a bottom wall 112 and a sidewall 114.

Each cavity 116 is formed by a two-stage process which will be described in the following. A first process will be described referring to Figure 1, and a subsequent second process will be described referring to Figure 2.

In said first process shown in Figure 1, a laser source 150 may be scanned over a pre-defined surface area of the electrically insulating layer structure 106. Consequently, a surface portion of the electrically insulating layer structure 106 adjacent to the first main surface 108 may be subjected to a laser impact. Thus, the boundaries of each cavity 116 may be defined by a laser treatment. Advantageously, the laser source 150 may be configured for emitting a green laser beam, especially a Bessel beam, for said laser treatment, for instance having a wavelength of 550 nm. The laser source 150 may be a pulsed laser, preferably a picosecond-pulsed laser, for said laser treatment. For said laser treatment, the laser beam of the laser source 150 may be scanned over surface regions of the first main surface 108 of the electrically insulating layer structure 106 in which the cavities 116 are to be formed. This defines the lateral boundaries and therefore the position of the sidewalls 114 of the cavities 116 to be formed. Advantageously, the laser light emitted by the laser source 150 can be focused during said laser treatment to an intended depth L of the respective cavity 116 in an interior of the electrically insulating layer structure 106. For example, said depth L of a respective cavity 116 may be in a range from 30 µm to 100 µm, for instance 60 µm.

By this processing, the laser light of green color emitted by the laser source 150 may impact the entire volume of the electrically insulating layer structure 106 in which volume the respective cavity 116 shall be formed. More precisely, the laser light impacting said glass volume of the electrically insulating layer structure 106 may locally modify glass properties of the electrically insulating layer structure 106 in which the at least one cavity 116 is to be formed. This modification may be a selective weakening of the glass material by the laser light which may render the laser irradiated glass volume of the electrically insulating layer structure 106 prone to subsequent removal in the below described second processing stage. Surprisingly, focusing the laser light to the intended depth L of the cavity 116 to be formed may reliably and precisely limit the vertical region of the electrically insulating layer structure 106 which is to be removed subsequently by etching. Summarizing, a focussed picosecond pulsed laser scans over the intended cavity region with adjusted laser beam size. The laser light is focused vertically up to an intended depth L of the cavity 116 to be created, wherein a corresponding vertical working distance of the laser beam can be adjusted by one or more lenses. Thus, a fast laser trepanning on the cavity area in focused depth treatment may be executed to modify chemical and physical properties of a defined glass volume of the electrically insulating layer structure 106. In particular, the described process is highly suitable for glass since it is capable to selectively attack silicon-oxide-bonds thereof. In particular, the power, the wavelength, the irradiation time, the scanning speed and/or the pulse parameters of the laser may be adjusted to selectively change properties of the irradiated portion of the electrically insulating layer structure 106 in accordance with its material attributes (for instance glass, ceramic or semiconductor).

Now referring to **Figure 2****,** the second processing stage for forming the cavities 116 will be explained. After having selectively exposed the intended cavity volume to laser irradiation according to Figure 1, the modified or weakened cavity volume material of the laser irradiated glass volume of the electrically insulating layer structure 106 is removed. This may be accomplished by chemical wet etching the electrically insulating layer structure 106 after said laser treatment. Such chemical wet etching may involve subjecting the first main surface 108 of the electrically insulating layer structure 108 to hydrofluoric acid (HF) based etchant. This chemical wet etching process allows to selectively remove the modified glass material which has been subjected to laser processing according to Figure 1. More specifically, a wet chemical solution (comprising HF) may be used for etching modified glass with high etching rate compared to pristine glass. This etching may lead to a slanted sidewall with a very high slanting angle close to a vertical direction. Thus, cavities 116 with substantially rectangular cross-section may be created.

Highly advantageously, the described manufacturing method allows to form the cavities 116 so that a surface of said bottom wall 112 and a surface of said sidewall 114 of each respective cavity 116 have a different roughness Ra than said first main surface 108 and than said second main surface 110 of the electrically insulating layer structure 106. As shown in a detail 152 of Figure 2, the roughness Ra may be significantly larger at the bottom wall 112 and the sidewall 114 of the cavity 116 as compared with the first main surface 108 and the second main surface 110. Beneficially, the increased roughness Ra-surfaces delimiting the cavities 116 may promote adhesion between the electrically insulating layer structure 106 and an electronic component (such as a semiconductor chip) when the latter is embedded in the cavity 116 (compare reference sign 136 in Figure 3). Further advantageously and still referring to the detail 152 of Figure 2, a minimum horizontal distance d between the first main surface 108 and the bottom wall 112 may be not more than 15 µm, for instance 10 µm. Thus, almost vertical sidewalls 114 may be obtained since the slanting angles of the sidewalls 114 may be much steeper than in conventional approaches of forming cavities in electrically insulating layer structures. Such almost vertical sidewalls 114 may be advantageous in terms of the compactness of the component carrier 100 and the controlled insertion of an electronic component in such a cavity 116.

**Figure 3** illustrates a cross-sectional view of a component carrier 100 according to an exemplary embodiment of the invention. For instance, the component carrier 100 according to Figure 3 may be embodied as an integrated circuit (IC) substrate or as a printed circuit board (PCB).

The illustrated component carrier 100 comprises a stack 102 having a plurality of electrically insulating layer structures 106 and a plurality of electrically conductive layer structures 104. For example, stack 102 may be a laminated layer stack composed of a lower sub-stack in form of a lower multilayer build-up 154 and of an upper sub-stack in form of an upper multilayer build-up 156, wherein the build-up layers may comprise a dielectric material such as resin, glass fiber or glass filler. A glass core 158 or glass plate forming a central electrically insulating layer structure 106 may be arranged between the lower multilayer build-up 154 and the upper multilayer build-up 156. Thus, said stack 102 comprises a central inorganic layer structure which is here embodied as glass core 158, but which may also be another inorganic layer structure (such as a ceramic or a semiconductor such as silicon). The lower multilayer build-up 154 is formed below the inorganic layer structure and the upper multilayer build-up 156 is formed above the inorganic layer structure. The electrically conductive layer structures 104 may comprise patterned copper layers which may form horizontal pads and/or a horizontal wiring structure. Additionally or alternatively, the electrically conductive layer structures 104 may comprise vertical through connections such as copper pillars and/or copper filled laser vias. Such vertical through connections are shown also in the glass core 158, wherein the density for the through connection may be different on the build-up layers of the two sides of the glass core. Moreover, the electrically insulating layer structures 106 above and beneath the glass core 158 may be for example prepreg or resin sheets. More generally, they may comprise resin, such as epoxy resin, and optionally reinforcing particles such as glass fibers or glass spheres. A lowermost electrically insulating layer structure 106 may be embodied as a patterned solder resist 160. Also an uppermost electrically insulating layer structure 106 may be embodied as a patterned solder resist 162.

On a bottom main surface of the component carrier 100, a plurality of electrically conductive connection elements 164, such as solder bumps, may be exposed with respect to the patterned solder resist 160. Said bottom-sided electrically conductive connection elements 164 may be configured for mounting the illustrated (for example integrated circuit (IC) substrate-type) component carrier 100 on a mounting base, such as a printed circuit board (PCB, not shown). On a top main surface of the component carrier 100, a plurality of electrically conductive connection elements 166, such as solder bumps, may be exposed with respect to the patterned solder resist 162. Said top-sided electrically conductive connection elements 166 may be configured for mounting one or more electronic components 168 on the top side of the component carrier 100. For instance, the surface-mounted electronic components 168 may be semiconductor chips.

As shown as well in Figure 3, electronic components 136 may be embedded in the stack 102. More precisely, each of said electronic components 136 may be inserted in an assigned one of the cavities 116 formed as described above referring to Figure 1 and Figure 2. Thanks to the intentionally high and locally increased (in particular higher than at the main surfaces 108, 110) roughness Ra of the sidewalls 114 and the bottom wall 112 of the respective cavity 116, an attaching film 132 at a bottom side of the respective electronic component 136 may adhere properly to the bottom wall 112 of the cavity 116. Descriptively speaking, the increased roughness Ra walls delimiting the respective cavity 116 may function as an adhesion promoter for the embedded electronic components 136 being embedded in the cavities 116. Remaining gaps in the cavity 116, i.e. gaps between the glass core 158 and the respective electronic component 136, may be filled with encapsulating material 134. Said encapsulating material 134 may originate from an electrically insulating layer structure 106 (for instance a sheet of prepreg, resin, photoimageable dielectric, a solder resist or glue) which may be attached directly to the upper main surface 108 of the inorganic electrically insulating layer structure 106 which is here embodied as glass core. Thereafter, a lamination process may be executed by elevating temperature and/or applying mechanical pressure. Consequently, still uncured resin of the electrically insulating layer structure 106 directly above the glass core may become flowable and may flow into void or hollow regions between the glass core 158 and the electronic components 136 in the cavities 116. During a curing process, the resin may polymerize and/or cross-link and may resolidify permanently to thereby form a solid encapsulating material 134 in direct physical contact with the glass core 158 and the embedded electronic components 136. Thus, the encapsulating material 134 is brought in direct physical contact with the sidewalls 114 and optionally the bottom wall 112 of the cavity 116 and with a surface of the electronic components 136. Also during formation of the encapsulating material 134, the locally increased roughness Ra may have a positive impact. As an alternative to the described lamination process, the encapsulating material 134 may also be inserted into the gaps between glass core 158 and electronic components 136, for instance as glue.

In an embodiment, electronic component 136 can be a bridge for components being surface mounted on the component carrier. Thus, it may be possible to shorten the electrical path among the component carrier, the bridge and the components mounted on the surface of the component carrier.

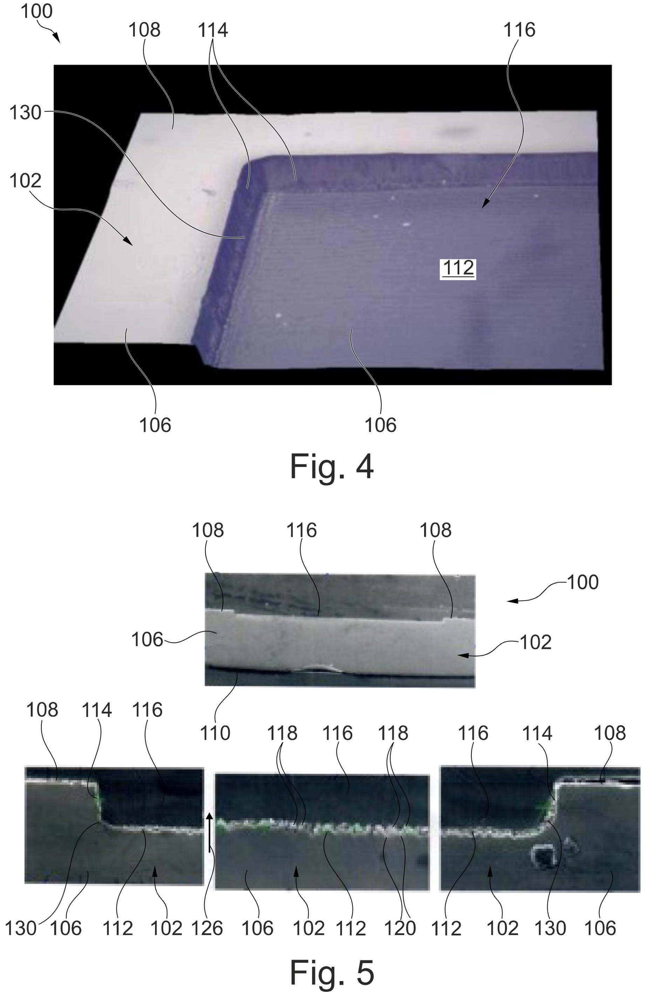

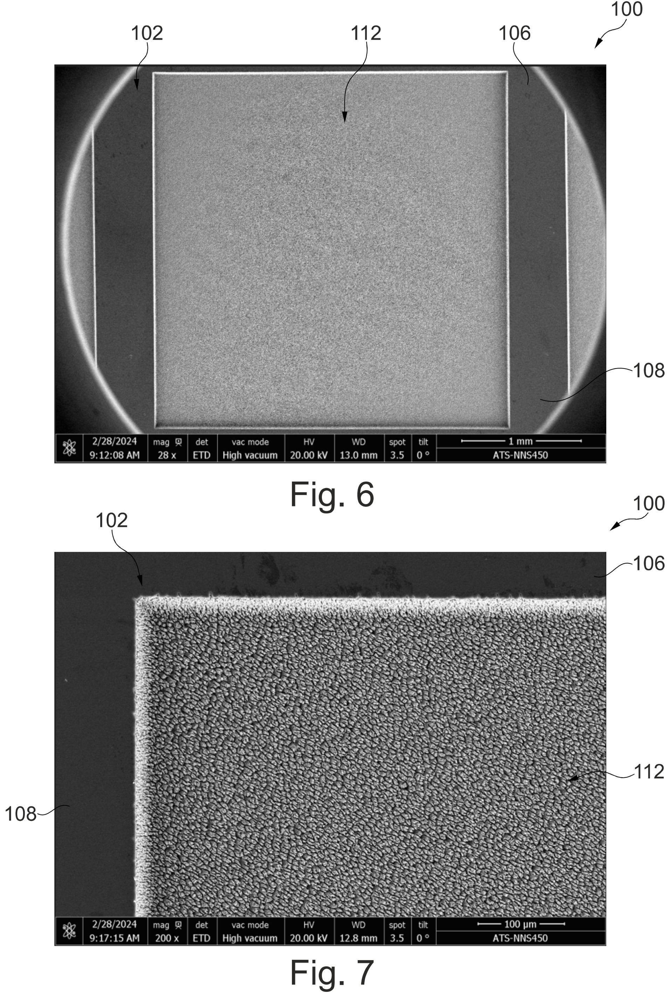

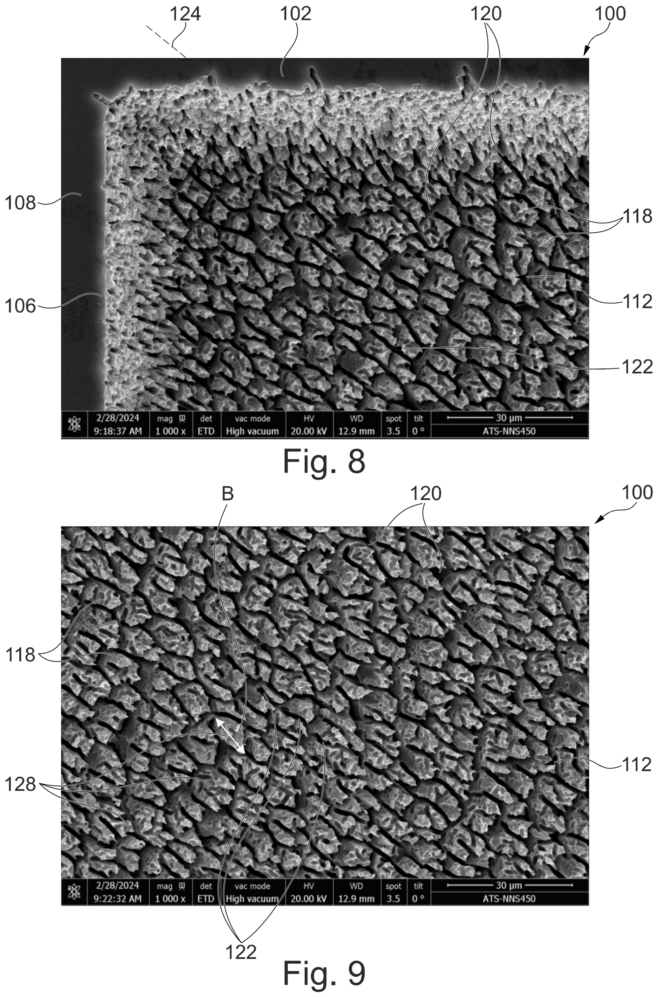

**Figure 4** illustrates a three-dimensional image of a component carrier 100 manufactured according to an exemplary embodiment of the invention. **Figure 5** illustrates different cross-sectional views of various portions of the component carrier 100 manufactured according to an exemplary embodiment of the invention. In particular, an overview of the region of the electrically insulating layer structure 106 around the cavity 116 shown on the top side of Figure 5. On the bottom side of Figure 5, different zoomed portions of and around the cavity 116 are shown, i.e. an interface between a left sidewall 114 and the first main surface 108 on the left-hand side, an interface between a right sidewall 114 and the first main surface 108 on the right-hand side, and a detailed view of the bottom wall 112 in the middle. Figure 6 to Figure 9 show plan views of portions of a component carrier 100 manufactured according to an exemplary embodiment of the invention with difference zooms. Figure 6 to Figure 9 show enlarged illustrations of bottom wall 112 of the cavity 116. More specifically, **Figure 7** shows a magnification over **Figure 6****,** **Figure 8** shows a magnification over Figure 7, and **Figure 9** shows a magnification over Figure 8.

As shown, the component carrier 100 comprises a stack 102 which may comprise one or more electrically insulating layer structures 106. The focus of Figure 4 and Figure 5 is an electrically insulating layer structure 106 made of glass and forming a core of the stack 102. In addition, one or more electrically conductive layer structures 104, for instance horizontal and/or vertically copper structure, may be present, which are however not visible in Figure 4 to Figure 9. The glass core-type electrically insulating layer structure 106 shown in Figure 4 and Figure 5 has a first main surface 108 and an opposing second main surface 110. Mostly, Figure 4 to Figure 9 show the first main surface 108 and features of a cavity 116 formed in said first main surface 108.

This cavity 116 being formed in the first main surface 108 is made of glass and is delimited by a bottom wall 112 and a sidewall 114. Advantageously, a surface of said bottom wall 112 and a surface of said sidewall 114 of the cavity 116 have a higher roughness Ra than a surrounding portion of said first main surface 108 of the electrically insulating layer structure 106, as best seen in the images on the left-hand side and on the right-hand side of Figure 5. This is due to the cavity manufacturing process which can be executed as described above referring to Figure 1 and Figure 2. Said bottom wall 112 may have another roughness Ra than or the same roughness Ra as said sidewall 114. In particular, said surface of said bottom wall 112 may have a higher roughness Ra than said surface of said sidewall 114. During a process of embedding an electronic component 136 in the cavity 116 (compare reference sign 136 in Figure 3), said roughness Ra of said surface of said bottom wall 112 and said surface of said sidewall 114 may provide an anchoring boundary region for anchoring an attaching film 132 and/or an encapsulating material 134 at said bottom wall 112 and said sidewall 114 of the cavity 116. Thus, the locally increased roughness Ra of the surface delimiting the cavity 116 may be of utmost advantage for improving integrity of a component carrier 100 with embedded electronic component 136 and avoid cracking of the glass core.

As best seen in the central detailed view of Figure 5 as well as in Figure 8 and Figure 9, the roughness Ra of said bottom wall 112 in the cavity 116 is defined by peaks 118 and valleys 120. Corresponding peaks 118 and valleys 120 may also be present at sidewall 114, see Figure 5 and Figure 8. Valleys 120 may be arranged along straight valley sections 122 in a plan view on the cavity 116, see Figure 8 and Figure 9. A majority of the valleys 120 (for instance more than 50% of the number of valleys 120) may be arranged along straight valley sections 122 extending substantially parallel to each other in a plan view on the cavity 116, see Figure 9 as well. Moreover, the majority of the valleys 120 may extend along an inclined direction 124 which may be a diagonal direction with respect to said sidewalls 114. This can be taken from Figure 8. Furthermore, said peaks 118 and valleys 120 may, in a thickness extension of the peaks 118, create undercuts along a thickness direction 126 of the stack 102. This can be seen in the lowermost central image of Figure 5. A thickness extension of peaks 118 on the bottom wall 112 may follow a different direction with respect to a thickness extension of peaks 118 on the sidewall 114, compare again Figure 5. The roughness Ra of said bottom wall 112 and of said sidewall 114 in the cavity 116 may be defined by the peaks 118 and the valleys 120 with their undercuts in the cavity 116 along the thickness direction 126 of the stack 102 by different extensions of the peaks 118.

Referring to Figure 9, said valleys 120 may divide said peaks 118 into islands 128 each comprising one or more of said peaks 118. A respective island 128 may be delimited by a groove around it, said groove being defined by one or more of said valleys 120. Some of said islands 128 may have, in a plan view of the at least one cavity 116, a length B in a range from 0.2 µm to 15 µm in a horizontal direction, compare Figure 9. Valleys 120 may be configured as a corridor adjacent to said islands 128.

Now referring to the bottom-sided images on the left-hand side and the right-hand side of Figure 5, said bottom wall 112 and said sidewall 114 may be connected to each other by a transitional wall 130 which may be a rounded wall. The sidewalls 114 of the cavity 116 may be substantially perpendicular to said first main surface 108 and said second main surface 110, for example within a deviation of ±10°. This deviation is much smaller than with conventionally manufactured cavities thanks to the manufacturing process described referring to Figure 1 and Figure 2. A thickness extension of the peaks 118 on the transitional wall 130 may be different from a thickness extension of the peaks 118 on the bottom wall 112 and the sidewall 114. In particular, the thickness extension of the peaks 118 on the transitional wall 130 may vary gradually from the thickness extension of the peaks 118 on the bottom wall 112 to the thickness extension of the peaks 118 on the sidewall 114.

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

## Claims

1. A component carrier (100), which comprises:
a stack (102) comprising at least one electrically conductive layer structure (104) and at least one electrically insulating layer structure (106), wherein the at least one electrically insulating layer structure (106) has a first main surface (108) and an opposing second main surface (110); and
at least one cavity (116) formed in the first main surface (108) of the at least one electrically insulating layer structure (106) and being delimited by a bottom wall (112) and a sidewall (114);
wherein a surface of said bottom wall (112) and a surface of said sidewall (114) of the at least one cavity (116) have a different roughness Ra than said first main surface (108) and/or than said second main surface (110) of the at least one electrically insulating layer structure (106).

2. The component carrier (100) according to claim 1, wherein the roughness Ra of said bottom wall (112) and/or said sidewall (114) in the at least one cavity (116) is defined by peaks (118) and valleys (120), wherein at least part of the valleys (120) are arranged along straight valley sections (122) in a plan view on the at least one cavity (116).

3. The component carrier (100) according to claim 1 or 2, wherein the roughness Ra of said bottom wall (112) in the at least one cavity (116) is defined by peaks (118) and valleys (120), wherein a majority of the valleys (120) are arranged along straight valley sections (122) extending substantially parallel to each other in a plan view on the at least one cavity (116),
in particular wherein the majority of the valleys (120) extend along an inclined direction (124), for instance along a diagonal direction, with respect to said sidewalls (114).

4. The component carrier (100) according to any of claims 1 to 3, wherein the roughness Ra of said bottom wall (112) and/or said sidewall (114) in the at least one cavity (116) is defined by peaks (118) and valleys (120), wherein a thickness extension of at least a plurality of the peaks (118) creates undercuts along a thickness direction (126) of the stack (102).

5. The component carrier (100) according to any of claims 1 to 4, wherein the roughness Ra of said bottom wall (112) and/or said sidewall (114) in the at least one cavity (116) is defined by peaks (118) and valleys (120), wherein a thickness extension of at least a plurality of the peaks (118) on the bottom wall (112) follows a different direction with respect to a thickness extension of at least a plurality of the peaks (118) on the sidewall (114).

6. The component carrier (100) according to any of claims 1 to 5, wherein the roughness Ra of said bottom wall (112) and/or said sidewall (114) in the at least one cavity (116) is defined by peaks (118) and valleys (120), wherein undercuts are provided in the at least one cavity (116) along a thickness direction (126) of the stack (102) by different extensions of the peaks (118).

7. The component carrier (100) according to any of claims 1 to 6, wherein the roughness Ra of said bottom wall (112) and/or said sidewall (114) in the at least one cavity (116) is defined by peaks (118) and valleys (120), wherein said valleys (120) divide said peaks (118) into islands (128) each comprising at least one of said peaks (118), for example a plurality of said peaks (118), in particular
wherein at least part of said islands (128) has, in a plan view of the at least one cavity (116), a length (B) in a range from 0.2 µm to 15 µm in at least one horizontal direction; and/or
wherein at least one of said valleys (120) is configured as a corridor adjacent to a plurality of said islands (128).

8. The component carrier (100) according to any of claims 1 to 7, wherein said bottom wall (112) and said sidewall (114) are connected to each other by a transitional wall (130), for example a rounded wall,
in particular wherein the roughness Ra of said bottom wall (112) and/or said sidewall (114) and/or said transitional wall (130) in the at least one cavity (116) is defined by peaks (118) and valleys (120), and wherein a thickness extension of the peaks (118) on the transitional wall (130) is different from a thickness extension of the peaks (118) on the bottom wall (112) and/or the sidewall (114),
more in particular wherein the thickness extension of the peaks (118) on the transitional wall (130) varies, for example gradually varies, from the thickness extension of the peaks (118) on the bottom wall (112) to the thickness extension of the peaks (118) on the sidewall (114).

9. The component carrier (100) according to any of claims 1 to 8, wherein the sidewall (114) of the at least one cavity (116) is substantially perpendicular to said first main surface (108) and/or said second main surface (110), for example within a deviation of ±10°.

10. The component carrier (100) according to any of claims 1 to 9,
wherein said surface of said bottom wall (112) has another roughness Ra than said surface of said sidewall (114); and/or
wherein said surface of said bottom wall (112) has a higher roughness Ra than said surface of said sidewall (114).

11. The component carrier (100) according to any of claims 1 to 10, wherein said roughness Ra of said surface of said bottom wall (112) and/or of said surface of said sidewall (114) provide an anchoring boundary region for anchoring an attaching film (132) and/or an encapsulating material (134) at said bottom wall (112) and/or said sidewall (114) of the at least one cavity (116).

12. The component carrier (100) according to any of claims 1 to 11, wherein a plurality of cavities (116) are formed in the first main surface (108) of the at least one electrically insulating layer structure (106), each of said cavities (116) being delimited by a respective bottom wall (112) and a respective sidewall (114),
in particular wherein different ones of said cavities (116) have different sizes, in particular in a horizontal plane and/or in a vertical direction.

13. The component carrier (100) according to any of claims 1 to 12, further comprising at least one of the following features:
wherein said first main surface (108) and/or said second main surface (110) is or are planar;
comprising at least one component (136) embedded in the at least one cavity (116);
comprising an attaching film (132) in said at least one cavity (116), wherein the at least one component (136) is attached by the attaching film (132);
wherein the at least one electrically insulating layer structure (106) comprises or consists of glass;
wherein the surface of said bottom wall (112) and the surface of said sidewall (114) have a higher roughness Ra than said first main surface (108) and/or than said second main surface (110);
wherein a minimum horizontal distance (d) between the first main surface (108) and the bottom wall (112) is not more than 50 µm, for example not more than 15 µm;
wherein a depth (L) of the at least one cavity (116) is in a range from 10 µm to 200 µm, for example from 30 µm to 100 µm.

14. A method of manufacturing a component carrier (100), wherein the method comprises:
providing a stack (102) comprising at least one electrically conductive layer structure (104) and at least one electrically insulating layer structure (106), wherein the at least one electrically insulating layer structure (106) has a first main surface (108) and an opposing second main surface (110);
forming at least one cavity (116) in the first main surface (108) of the at least one electrically insulating layer structure (106) and being delimited by a bottom wall (112) and a sidewall (114); and
forming the at least one cavity (116) so that a surface of said bottom wall (112) and a surface of said sidewall (114) of the at least one cavity (116) have a different roughness Ra than said first main surface (108) and/or than said second main surface (110) of the at least one electrically insulating layer structure (106).

15. The method according to claim 14, further comprising at least one of the following features:
wherein the method comprises forming the at least one cavity (116) using a laser treatment;
wherein the method comprises forming the at least one cavity (116) using etching, for example wet etching, after said laser treatment;
wherein the method comprises using a laser beam having a wavelength in a range from 520 nm to 580 nm, in particular a green laser, for said laser treatment;
wherein the method comprises using a pulsed laser, for example a picosecond-pulsed laser, for said laser treatment;
wherein the method comprises, for said laser treatment, scanning with a laser beam over a surface region of the at least one electrically insulating layer structure (106) in which the at least one cavity (116) is to be formed;
wherein the method comprises focusing, for said laser treatment, laser light to an intended depth (L) of the at least one cavity (116) to be formed in the at least one electrically insulating layer structure (106);
wherein the method comprises configuring laser light, for said laser treatment, for modifying a glass property of the at least one electrically insulating layer structure (106) in which the at least one cavity (116) is to be formed.
